# EUROPEAN PATENT APPLICATION

(11) **EP 1 972 976 A2**
(43) Date of publication of application: **24.09.2008**
(21) Application number: 08102646.0
(22) Date of filing: 16.03.2008
(51) Int. Cl.: G02B 6/42, H01L 23/544

(54) **Marked body and manufacturing method thereof**

(30) Priority: 23.03.2007 JP 2007077567; 18.01.2008 JP 2008009653
(71) Applicant: NEC CORPORATION, Tokyo (JP)
(72) Inventor: Watanabe, Shinya, Tokyo (JP)
(74) Representative: Betten & Resch

(57) **Abstract**

To provide a marked body that can bear the temperature of heat treatment that is required for a PLC. A lower clad layer, a marked body, a cylindrical part, a buried layer, and an upper clad layer are laminated on a silicon substrate. The marked body is formed with a void that is formed in the buried layer made with a silicon oxide film. Therefore, the heat resistance can be improved dramatically compared to a case of the marked body that is made of metal or the like. Moreover , the refractive index within the void is about 1, so that it is possible to have a sufficient difference between the diffractive index of the material of the periphery of the void and the diffractive index within the void. This makes it possible to achieve a high-contrast marked body.

## Description

### CROSS-REFERENCE TO RELATED APPLICATIONS

This application is based upon and claims the benefit of priority from Japanese patent application No. 2007-077567, filed on March 23, 2007, and Japanese patent application No. 2008-009653, filed on January 18, 2008, the disclosure of which is incorporated herein in its entirety by reference.

### BACKGROUND OF THE INVENTION

### 1. Field of the Invention

The present invention relates to a marked body that is used for positioning work such as passive alignment and for indicating information, and to a manufacturing method thereof.

### 2. Description of the Related Art

There are a microoptics type module and a planar lightwave circuit (referred to as "PLC" hereinafter) module as optical transceivers used on the market of the optical access. The microoptics type module is configured with components such as a laser diode (referred to as "LD" hereinafter), a photodiode (referred to as "PD" hereinafter), a thin film filter, and a lens. The PLC module has a quartz waveguide formed on a silicon substrate, and an LD, PD, and the like are mounted to the surface thereof. Both have merits and demerits. However, the PLC module that requires no adjustment of optical axis while monitoring output of light is advantageous in terms of the cost and delivery. A mounting method of such PLC module is generally referred to as passive alignment mounting. There are various techniques regarding the passive alignment mounting (for example, see Japanese Unexamined Patent Publication 2002-62447 (Document 1) and Japanese Unexamined Patent Publication 2003-512645 (Patent Document 2)).

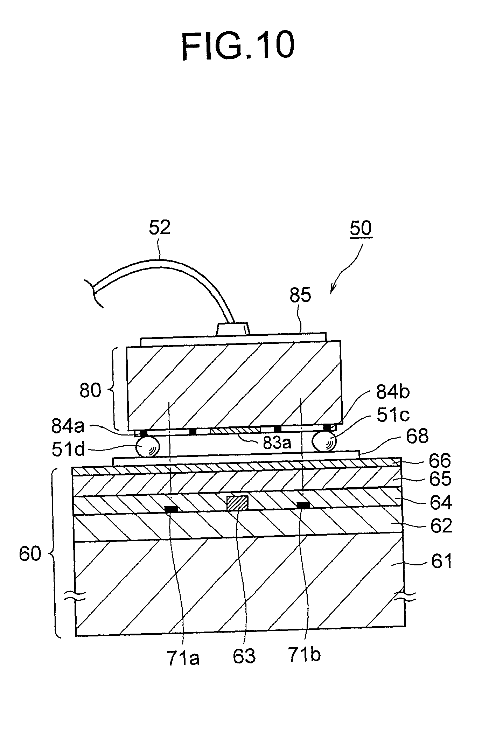

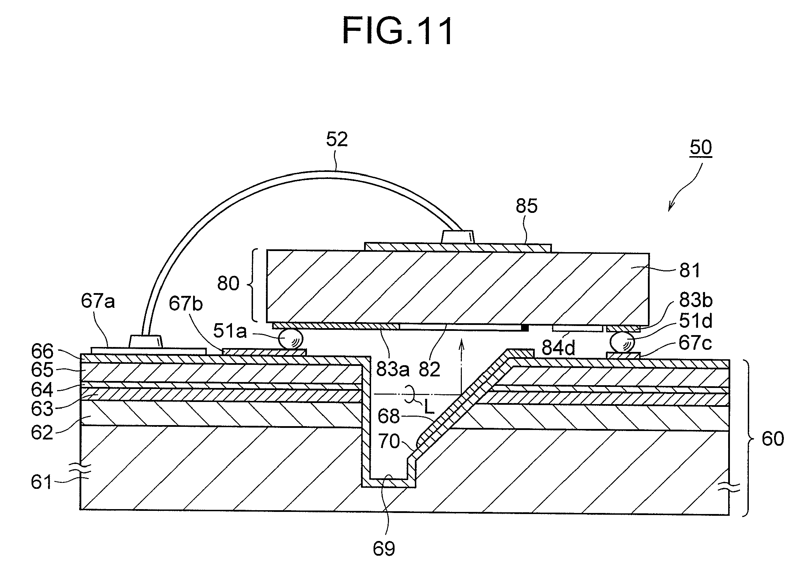

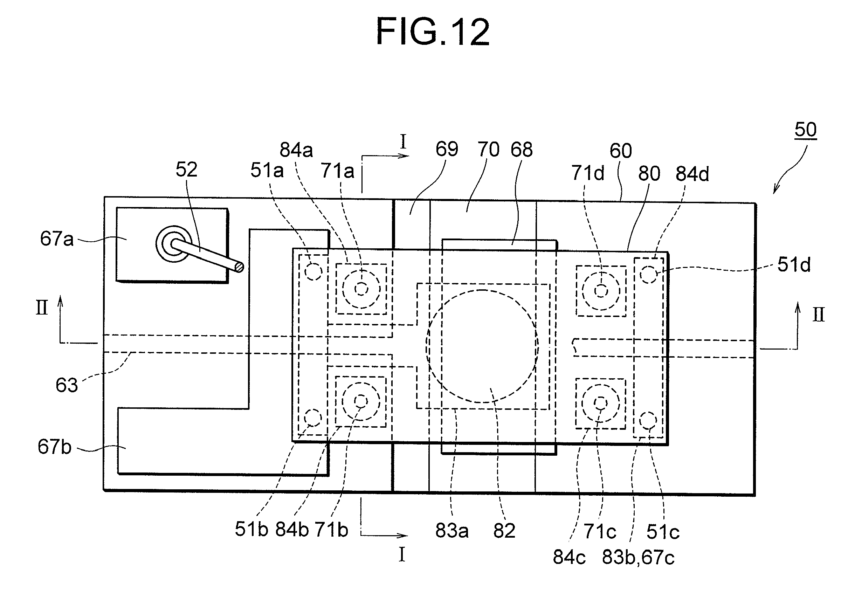

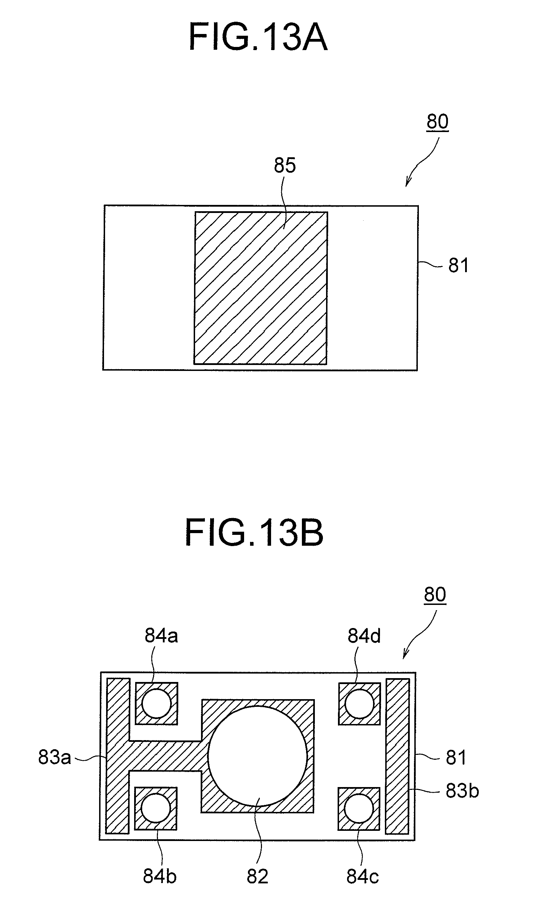

FIG. 10 - FIG. 12 illustrate an example of an optical waveguide device that employs the passive alignment mounting. FIG. 10 is a longitudinal sectional view taken along a line I-I of FIG. 12, FIG. 11 is a longitudinal sectional view taken along a line II-II of FIG. 12, and FIG. 12 is a plan view. FIGS. 13A and 13B show a PD chip that is a part of the optical waveguide device shown in FIG. 10 - FIG. 12, in which FIG. 13A is a plan view and FIG. 13B is a bottom view. Explanations will be provided hereinafter by referring to FIG. 10 - FIG. 13A and 13B.

An optical waveguide device 50 is a PLC module configured with a PLC 60 and a PD chip 80. The PD chip 80 is mounted on the PLC 60 by passive alignment. The PLC 60 includes, on a silicon substrate 61, a lower clad layer 62, a core, 63, a buried layer 64, an upper clad layer 65, a mirror flattening layer 66, electrodes 67a, 67b, 67c, a mirror 68, a groove 69, a sloping face 70, marked bodies 71a - 71d, and the like. The PD chip 80 includes a chip main body 81 made of a compound semiconductor or the like, a light receiving face 82 formed on the bottom face of the chip main body 81, electrodes 83a, 83b, marked bodies 84a - 84d, and an electrode 85 formed on the top face of the chip main body 81. The electrode 83a of the PD chip 80 is connected on the electrode 67b of the PLC 60 via bumps 51a, 51b, and the electrode 83b of the PD chip 80 is connected on the electrode 67c of the PLC 60 via bumps 51c, 51d. The electrode 85 of the PD chip 80 is connected on the electrode 67a of the PLC 60 via a wire 52. However, the electrode 85 of the PD chip 80 is omitted in FIG. 12 for avoiding complication. In FIG. 13A and 13B, a metal film for forming the electrodes 83a, 83b and the marked bodies 84a - 84d is indicated with hatching.

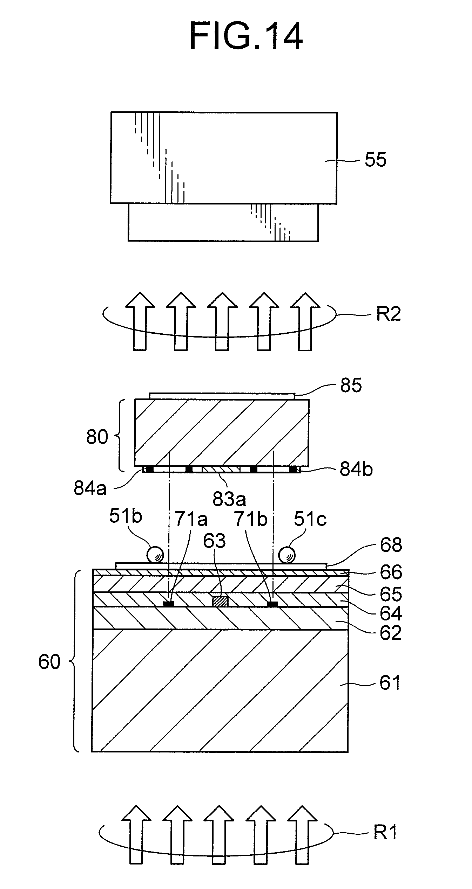

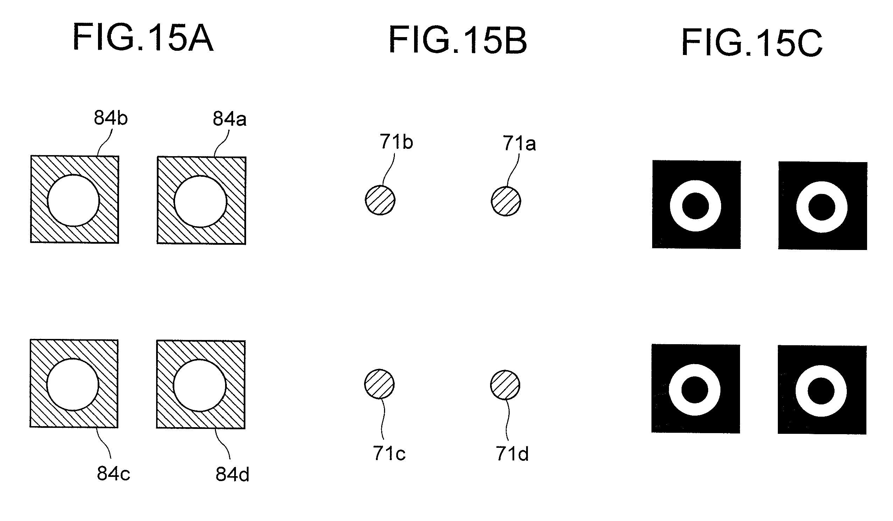

FIG. 14 is an illustration for describing passive alignment mounting of the optical waveguide device shown in FIG. 10. FIGS. 15A - 15C show plan views of marked bodies and images used in the passive alignment mounting shown in FIG. 14, in which FIG. 15A shows marked bodies of the PD chip, FIG. 15B shows the marked bodies of the PLC, and FIG. 15C shows images obtained by overlapping both marked bodies one over another . The passive alignment mounting will be described hereinafter by referring to FIG. 10 - FIGS. 15A - 15C.

As shown in FIG. 10 - FIG. 12, the optical waveguide device 50 operates to reflect emitted light L from the core 63 as the optical waveguide towards the upper direction by the mirror 68 so as to guide it to the light receiving face 82 of the PD chip 80 that is mounted on the surface of the PLC 60. If the PD chip 80 is not mounted to the PLC 60 with high precision with respect to the core 63 and the mirror 68 of the PLC 60, eclipse of light occurs on the light receiving face 82, thereby deteriorating the light receiving efficiency. This tendency becomes prominent as the diameter of the light receiving face 82 of the PD chip 80 becomes smaller. Thus, the marked bodies 71a - 71d and 84a - 84d used for mounting are provided to the PLC 60 and the PD chip 80, respectively. Then, as shown in FIG. 14, infrared light R1 is irradiated from the bottom face of the PLC 60, and infrared light R2 transmitted through the PLC 60 and the PD chip 80 is recognized by a camera 55. At this time, the PD chip 80 is mounted to the PLC 60 through aligning the marked bodies 71a, --- and the marked bodies 84a, -- in such a manner that the centers thereof match with each other. With this, the positional relation between the PLC 60 and the PD chip 80 can be maintained with high precision, so that a stable light receiving efficiency can be obtained.

As described above, the PLC 60 and the PD chip 80 are arranged one over another , and the images of both marked bodies 71a, --- and the marked bodies 84a, --- are recognized by the infrared light R2 that has transmitted through the PLC 60 and the PD chip 80. At this time, it is necessary to form the marked bodies 71a, --- and the marked bodes 84a, --- with a material that shields the infrared light for recognizing the marked bodies 71a, --- and the marked bodes 84a. For example, when the marked bodies 84a - 84d in a shape as shown in FIG. 15A are formed on the PD chip 80 side, and the marked bodies 71a - 71d in a shape as shown in FIG. 15B are formed on the PLC 60 side, an image in a shape as shown in FIG. 15C is observed on a recognition screen. Highly accurate mounting can be achieved by aligning the marked bodies 71a, --- and the marked bodies 84a, --- in such a manner that the centers thereof match with each other.

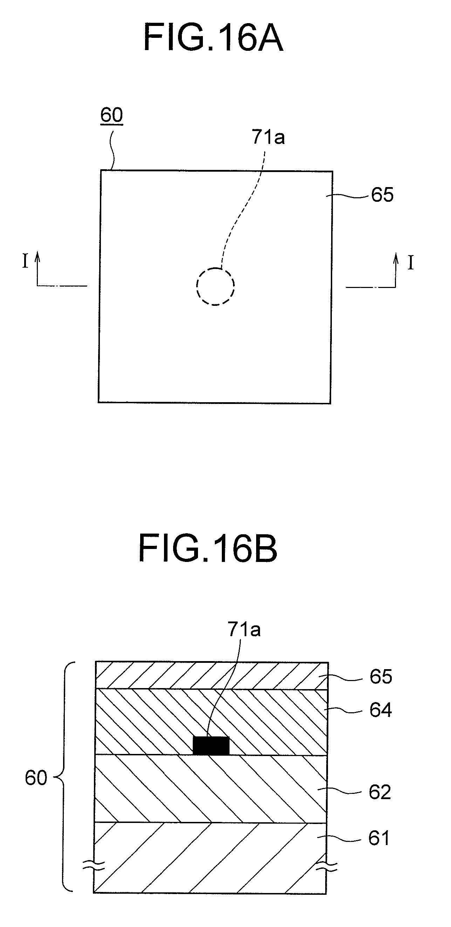

FIGS. 16A and 16B show the marked body on the PLC side, in which FIG. 16A is a plan view, and FIG. 16B is a longitudinal sectional view taken along a line I-I of FIG. 16A. Explanations will be provided hereinafter by referring to those drawings. Same numeral references are applied to the same components as those of FIG. 10, and explanations thereof are omitted.

FIGS. 16A and 16B are fragmentary views showing a part of the PLC 60 that is shown in FIG. 10. The lower clad layer 62, the marked body 71a, the buried layer 64, and the upper clad layer 65 are laminated on the silicon substrate 61. For the material of the marked body 71a, chrome is used as a metal film.

FIGS. 17A - 17G show a manufacturing method of the PLC including the marked bodies shown in FIG. 14, and steps thereof are executed in order from FIG. 17A to FIG. 17G. Explanations thereof will be provided hereinafter by referring to those drawings.

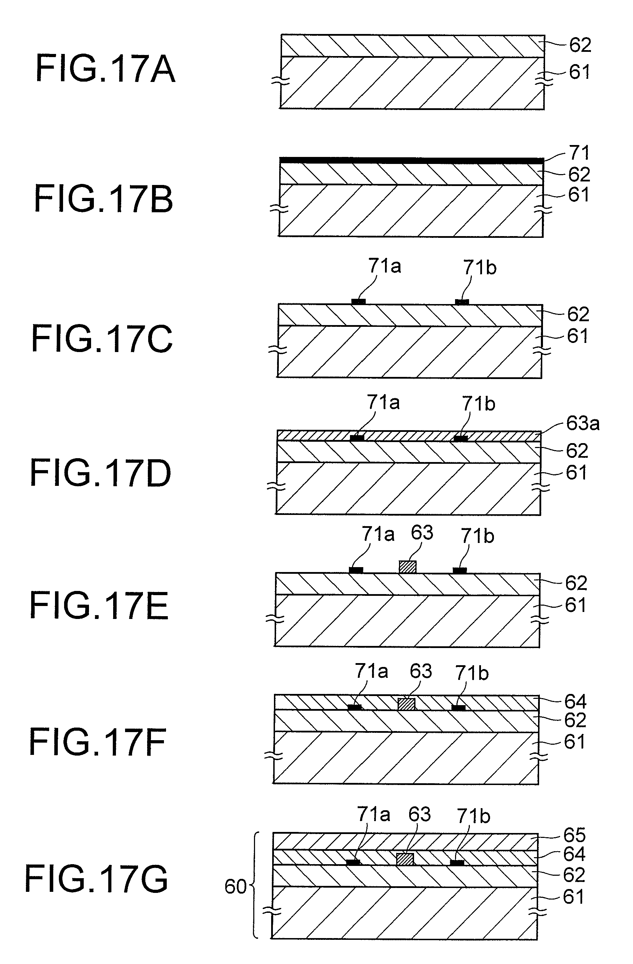

First, the lower clad layer 62 made of a silicon oxide film is formed on the silicon substrate 61 by plasma CVD. Thereafter, heat treatment is applied with a prescribed condition (FIG. 17A) . Subsequently, a chrome film 71 to be the marked bodies 71a, 71b is formed on the lower clad layer 62 (FIG. 17B). Then, a resist pattern in a prescribed shape is formed on the chrome film 71 by photolithography, and the chrome film 71 is etched to form the marked bodies 71a and 71b (FIG. 17C) .

A core layer 63' that is to be the core 63 later is formed thereon by plasma CVD. Thereafter, heat treatment is applied again with a prescribed condition (FIG. 17D). In this heat treatment, the temperature needs to be set to such a value or less so that chrome used for forming the marked bodies 71a and 71b can bear the heat. There is a same restriction set for the heat treatments applied hereinafter.

Subsequently, by having the marked bodies 71a, 71b as the reference points, a resist pattern in a prescribed shape is formed on the core layer 63' by photolithography, and the core layer 63' is etched to form the core 63 (FIG. 17E). Shift generated at this time between a mask for forming the core 63 and the marked bodies 71a, 71b becomes position shift between the PD chip 80 and the core 63, which are mounted later by passive alignment.

Subsequently, the buried layer 64 is formed thereon, and heat treatment is applied thereto to fuse the buried layer 64 to bury the core 63 therein, and the surface is flattened (FIG. 17F). Lastly, the upper clad layer 65 is formed thereon, and heat treatment is applied thereto to complete the basic structure of the PLC 60 (FIG. 17G). In addition, steps for forming the electrodes and the mirror are added or inserted when necessary.

However, there are following issues in the conventional marked bodies that are formed with a metal film.
(a) Normally, in a PLC manufacturing step, heat treatment at an extremely high temperature (for example, 1,000 °C) is required for separating OH radical and NH radical, which give influences to light loss, and for burying the waveguide. However, metals that are typical light shielding materials (for example, chrome) are oxidized and deformed at a certain temperature or higher, or position thereof may be shifted due to reflow of a silicon oxide film that configures the waveguide. Thus, the temperature of the heat treatment cannot be increased to such an extent that is sufficient for making it fully transparent as the waveguide, so that it is unavoidable to sacrifice the basic property of the waveguide, e.g. propagation loss. This issue can be avoided by a method with which the marked bodies are patterned by using the core as a reference, after completing the heat treatment that is applied after forming the upper clad layer. In that case, however, the height position of the core and that of the marked body become largely different. Therefore, when a marked-body patterning mask is aligned with respect to the core, the core becomes defocused. As a result, the marked body cannot be formed with high precision with respect to the core position.
(b) A positioning error is generated between the marked body and the core, because the core is formed by having the marked body as a reference. This shift is generated necessarily in no small extent due to a warp of a wafer caused due to heat treatment, due to mask aligner precision, or the like. Therefore, there is shift generated between the optical axes even if the marked bodies are aligned with each other with high precision by passive alignment.
(c) The manufacturing steps become complicated, since a metal film forming step, a photolithography step, an etching step, and the like are required.

### SUMMARY OF THE INVENTION

An exemplary object of the present invention is to provide a marked body that can bear the temperature of heat treatment.

In order to achieve the foregoing exemplary object, a marked body according to an exemplary aspect of the invention is a marked body including a marking whose presence is recognized by irradiation of light, wherein the marking is formed inside a transparent layer, and the marking generates a contrast difference between a periphery and itself by diffracting irradiated light.

Further, a marked body manufacturing method according to another exemplary aspect of the invention is a method for manufacturing a marked body whose presence is recognized by irradiation of light, wherein a marking for generating a contrast difference between a periphery and itself by diffracting irradiated light is formed inside a transparent layer.

As an exemplary advantage according to the invention, it is possible to improve the heat resistance dramatically compared to the case of using a metal-made marked body and to achieve the same-level contrast as that of the metal-made marked body by diffraction of a marking, through forming, inside a transparent layer, the marking for generating a contrast difference between the periphery and itself by diffracting the irradiated light (for example, through forming a void and using it as the marking).

### BRIEF DESCRIPTION OF THE DRAWINGS

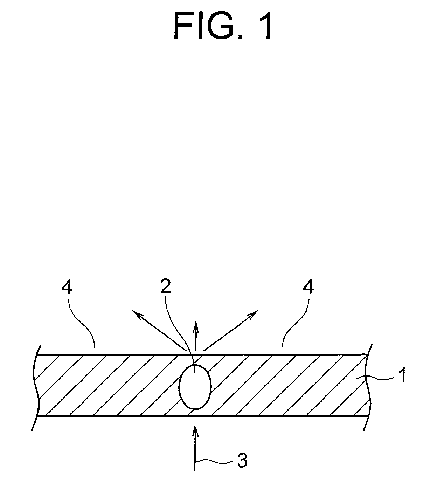

FIG. 1 is a sectional view showing a basic structure of a marked body according to exemplary embodiments of the present invention;

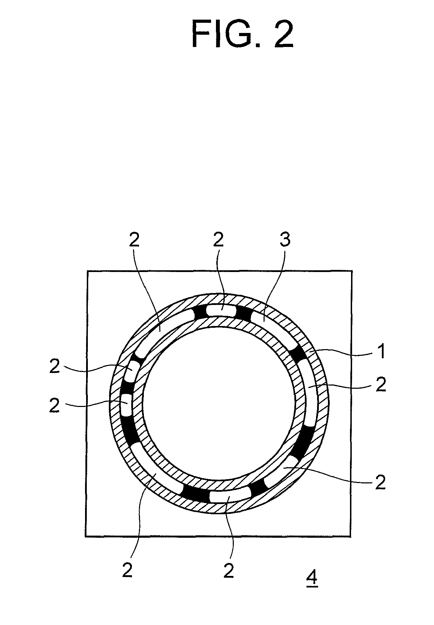

FIG. 2 is a plan view showing a modification example of the marked body shown in FIG. 1;

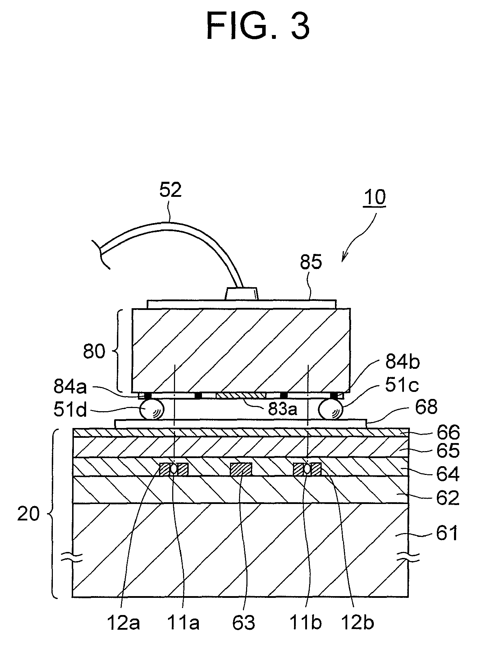

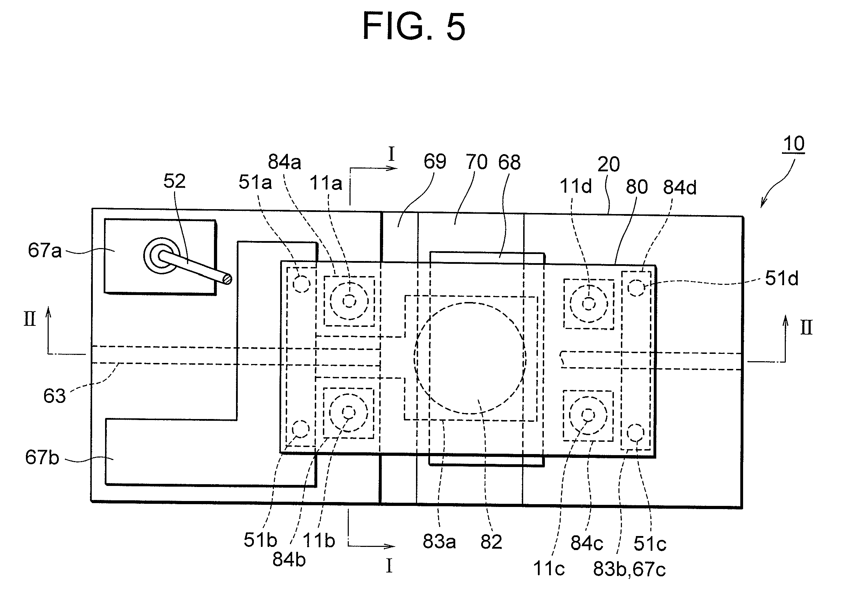

FIG. 3 is a longitudinal sectional view taken along a line I-I of FIG. 5, showing an optical waveguide device according to a first exemplary embodiment of the present invention;

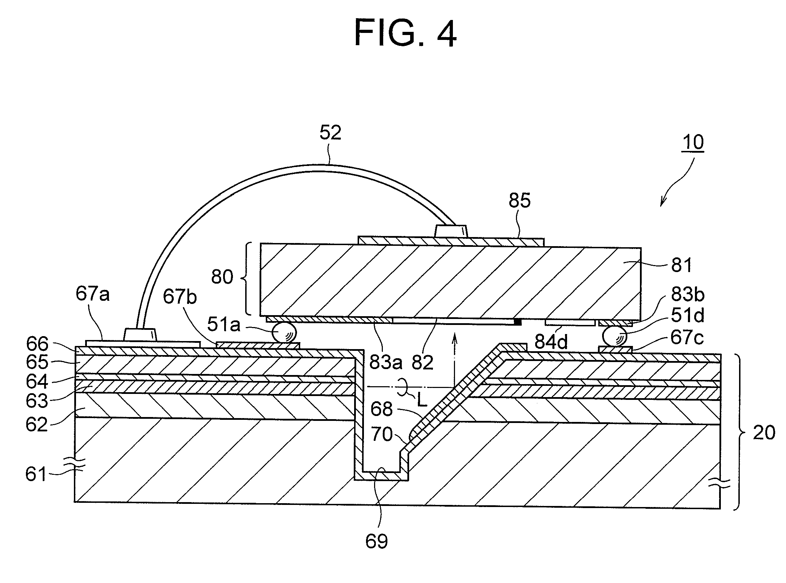

FIG. 4 is a longitudinal sectional view taken along a line II-II of FIG. 5, showing the optical waveguide device according to the first exemplary embodiment of the present invention;
FIG. 5 is a plan view showing the optical waveguide device according to the first exemplary embodiment of the present invention;

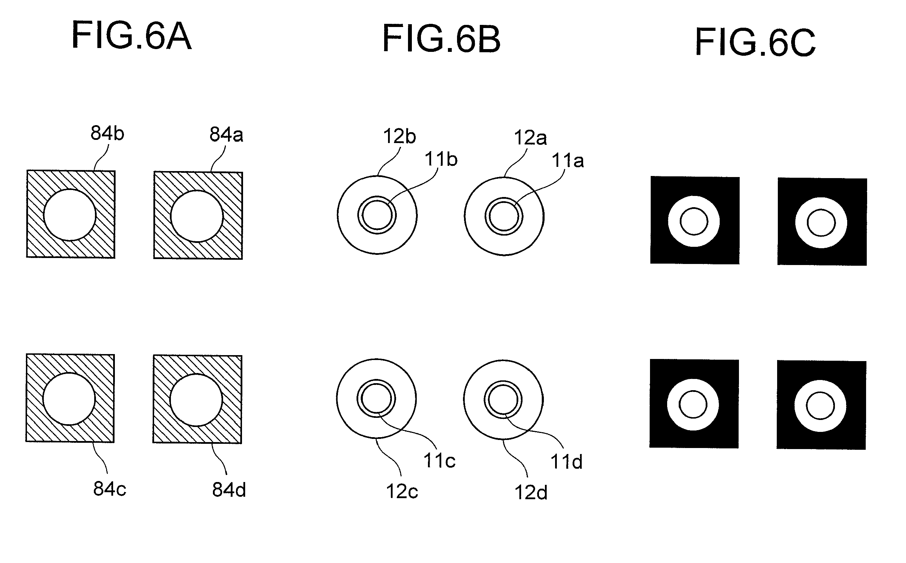

FIGS. 6A - 6C show plan views showing the marked body shown in FIG. 1 and an image thereof, in which FIG. 6A shows marked bodies of a PD chip, FIG. 6B shows marked bodies of a PLC, and FIG. 6C shows an image obtained by overlapping both marked bodies one over another;

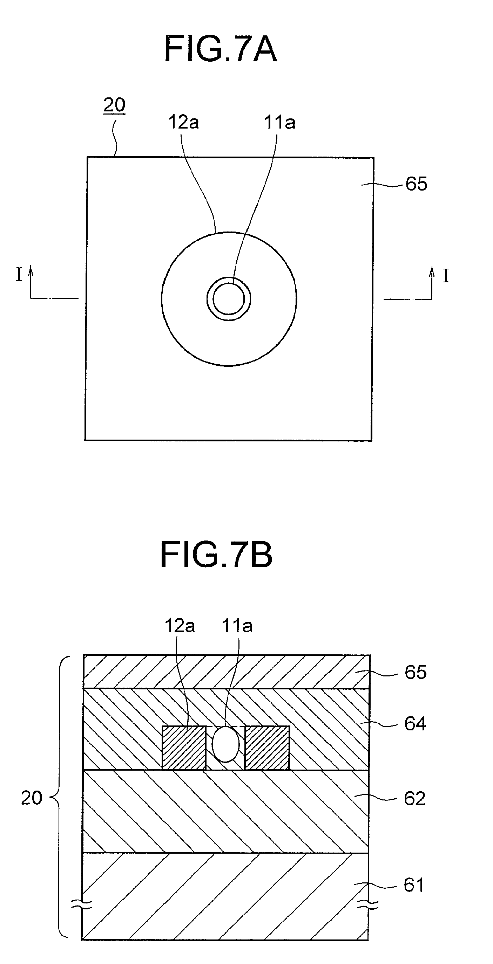

FIGS. 7A and 7B show a marked body shown in FIG. 3, in which FIG. 7A is a plan view and FIG. 7B is a longitudinal sectional view taken along a line I-I of FIG. 7A;

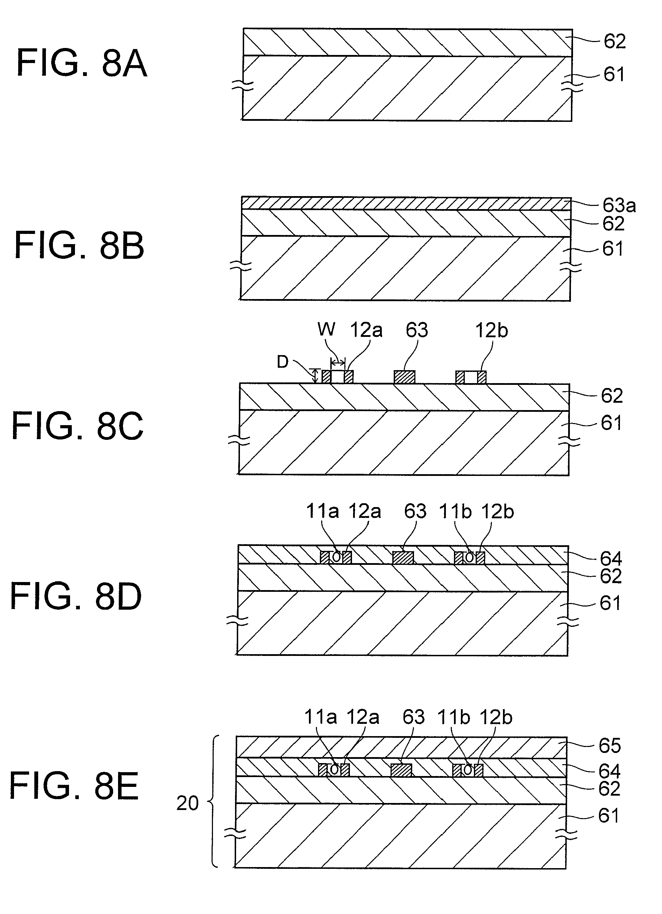

FIGS. 8A - 8E are sectional views showing a manufacturing method of the PLC shown in FIG. 1, in which FIGS. 8A - 8E show the order of steps with which the procedure is executed;

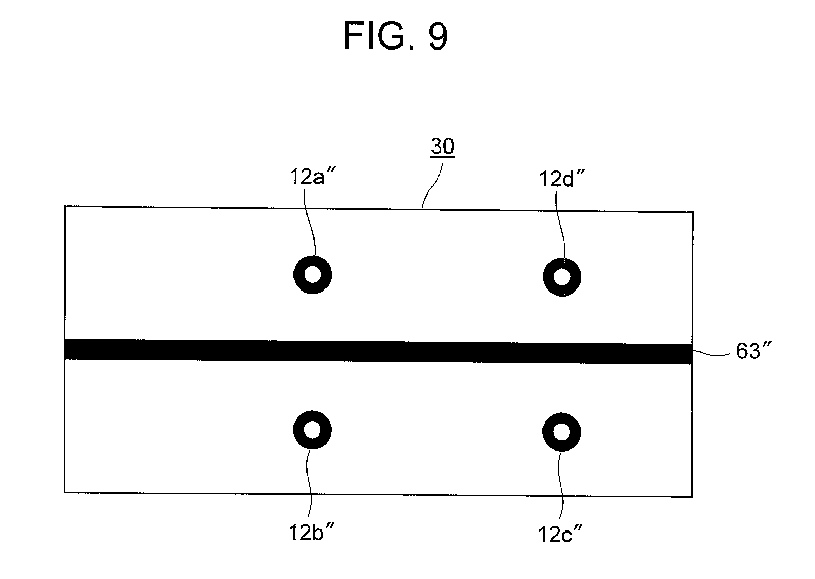

FIG. 9 is a plan view showing an example of a mask used in the steps of FIGS. 8A - 8E;
FIG. 10 is a longitudinal sectional view taken along a line I-I of FIG. 12, showing an example of a related optical waveguide device;
FIG. 11 is a longitudinal sectional view taken along a line II-II of FIG. 12, showing an example of the related optical waveguide device;
FIG. 12 is a plan view showing an example of the related optical waveguide device;
FIGS. 13A and 13B show a PD chip that is a part of the optical waveguide device shown in FIG. 10, in which FIG. 13A is a plan view and FIG. 13B is a bottom view;
FIG. 14 is an illustration for describing passive alignment mounting in the optical waveguide device shown in FIG. 10;
FIGS. 15A - 15C show plan views illustrating marked bodies used in the passive alignment mounting of FIG. 14 and an image thereof, in which FIG. 15A shows marked bodies of the PD chip, FIG. 15B shows marked bodies of the PLC, and FIG, 15C shows an image obtained by overlapping both marked bodies one over another;
FIGS. 16A and 16B show a related marked body on the PLC side, in which FIG. 16A is a plan view and FIG. 16B is a longitudinal sectional view taken along a line I-I of FIG. 16A; and
FIGS. 17A - 17G are sectional views showing a manufacturing method of the PLC including the marked body shown in FIGS. 16A and 16B, in which FIGS. 17A - 17G show the order of steps with which the procedure is executed.

### DETAILED DESCRIPTION OF THE EXEMPLARY EMBODIMENTS

As shown in FIG. 1, a marked body according to an exemplary embodiment of the invention is a marked body whose presence is recognized by irradiation of light, which includes, as a basic structure, a marking 2 formed within a transparent layer 1. The marking 2 generates a contrast difference between the periphery thereof and itself by diffracting irradiated light 3.

As shown in FIG. 1 , when the light 3 is irradiated to the marking 2 within the layer 1, the marking 2 diffracts the light 3 as illustrated with arrows to generate a contrast difference between a periphery 4 and itself. Therefore, the marking 2 can be recognized from the contrast difference with respect to the periphery through optically monitoring the state where the marking 2 diffracts the light 3.

While a single marking 2 illustrated in FIG. 1, the number is not limited to that. As shown in FIG. 1, the marking 2 may be formed individually as a single structure, so that the marking 2 itself generates a contrast difference with respect to the periphery 4. Thus, it may be configured as a marked body for identifying a position to be specified. Further, as shown in FIG. 2, a plurality of markings 2 may be combined to form a structure which determines the position to be specified based on the positional relation between each of the markings 2. In the case of FIG. 2, the marked body configured with a plurality of markings 2 generates a contrast difference with respect to the periphery 4 inside and outside areas of a ring segment, and it is used as a marked body for a case where the center position of the ring is identified by utilizing the contrast difference. While the plurality of markings 2 of the marked body are arranged in a ring shape in FIG. 2, it is not limited only to that. The form of arranging the plurality of markings 2 can be changed variously by considering the purpose for using the marked body.

For manufacturing the marked body according to the exemplary embodiment of the present invention, the marking 2 that generates a contrast difference with respect to the periphery by diffracting the irradiated light is formed inside the transparent layer 1. More specifically, in a process of forming an optical waveguide of a planar lightwave circuit (PLC), for example, voids are formed actively, for example, on a layer where the optical waveguide is to be formed, so as to use the voids as the markings 2.

With the exemplary embodiment of the present invention, it is possible to improve the heat resistance dramatically compared to the case of using a metal-made marked body and to achieve the same-level contrast as that of the metal-made marked body by diffraction of a marking, through forming, inside a transparent layer, the marking for generating a contrast difference between the periphery and itself by diffracting the irradiated light (for example, through forming a void and using it as the marking).

Next, the marked body according to the exemplary embodiment of the present invention will be described in more details.

### (FIRST EXEMPLARY EMBODIMENT)

As a first exemplary embodiment, there is described marked body that is obtained by selecting a layer for forming an optical waveguide of a planar lightwave circuit (PLC) as the layer 1 shown in FIG. 3 and by forming the marking 2 on the layer.

As shown in FIG. 3 - FIG. 5, an optical waveguide device 10 is configured by hybrid mounting a PD chip 80 on a planar lightwave circuit (referred to as PLC hereinafter) 20 by passive alignment.

As shown in FIG. 3, the PLC 20 includes, on a silicon substrate 61, a lower clad layer 62, a core 63, a buried layer 64, an upper clad layer 65, a mirror flattening layer 66, electrodes 67a, 67b, 67c, a mirror 68, a groove 69, a sloping face 70, marked bodies 11a- 11d, cylindrical parts 12a, 12b, ---, and the like. That is, the lower clad layer 62 is laminated on the silicon substrate 61, the core 63 and the cylindrical parts 12a, --- are provided on a part of the lower clad layer 62, and the buried layer 64 is laminated thereover. Thereby, the marked bodies 11a - 11d formed with voids are formed within the cylindrical parts 12a, ---, and the upper clad layer 65 is laminated on the buried layer 64. The electrodes 67a, 67b, 67c, and the mirror 68 are made of gold.

The layer 1 having transparency, which is shown in FIG. 1, is formed within a layer where the optical waveguide of the PLC 20 is formed in FIG. 3 (specifically, within the same layer as that of the core 63 that has the voids 11a, 11b as the marking 2 shown in FIG. 1 formed on the clad layer 62). The same layer as the core 63 is formed by the same material as the core 63. The same layer as the core 63 is included inside the buried layer 64, so that only the buried layer 64 is illustrated in FIG. 2. The same layer as the core 63 will be described more specifically in the explanations of the manufacturing method. While the voids 11a and 11b serving as the markings 2 are formed on the same layer as the core 63, it is not limited only to such case. For example, the voids may be formed on a part of the lower clad layer 62, the upper clad layer 65, the buried layer 64, or the like. Further, the silicon substrate 61 is used as a substrate, and the PD chip 80 is used as an optical element.

The PD chip 80 includes a chip main body 81 made of a compound semiconductor or the like, a light receiving face 82 formed of the bottom face of the chip main body 81, electrodes 83a, 83b, marked bodies 84a - 84d, and an electrode 85 formed on the top face of the chip main body 81. The electrode 83a of the PD chip 80 is connected on the electrode 67b of the PLC 20 via bumps 51a, 51b, and the electrode 83b of the PD chip 80 is connected on the electrode 67c of the PLC 20 via bumps 51c, 51d. The electrode 85 of the PD chip 80 is connected on the electrode 67a of the PLC 20 via a wire 52. The wire 52 is made of gold. The bumps 51a, --- are made of solder or gold. However, the electrode 85 of the PD chip 80 is omitted in FIG. 5 for avoiding complication. The electrodes 83a, 83b and the marked bodies 84a - 84d are the same as those shown in FIGS. 13A and 13B.

FIGS. 6A - 6C show plan views of the marked body shown in FIG. 1 and an image thereof, in which FIG. 6A shows the marked bodies of the PD chip, FIG. 6B shows the marked bodies of the PLC, and FIG. 6C shows an image obtained by overlapping both marked bodies one over another. Explanations are provided hereinafter by referring to FIG. 1 - FIG. 4.

As shown in FIG. 3 - FIG. 5, the optical waveguide device 10 operates to reflect emitted light L from the core 63 as the optical waveguide towards the upper direction by the mirror 68 so as to guide it to the light receiving face 82 of the PD chip 80 that is mounted on the surface of the PLC 20. If the PD chip 80 is not mounted with high precision with respect to the core 63 and the mirror 68 of the PLC 20, eclipse of light occurs on the light receiving face 82, thereby deteriorating the light receiving efficiency. This tendency becomes prominent as the diameter of the light receiving face 82 of the PD chip 80 becomes smaller. Thus, the marked bodies 11a - 11d and 84a - 84d used for mounting are provided to the PLC chip 20 and the PD chip 80, respectively. Then, as in the method shown in FIG. 14, the PD chip 80 is mounted to the PLC 20 through aligning the marked bodies 11a, --- and the marked bodies 84a, -- in such a manner that the centers thereof match with each other. With this, the positional relation between the PLC 20 and the PD chip 80 can be maintained with high precision, so that a stable light receiving efficiency can be obtained.

The marked bodies 84a, --- are formed with a metal film, thereby shielding the infrared light. The marked bodies 11a, --- are formed with voids, thereby diffracting the infrared light (includes diffraction, reflection, and the like). With this, the marked bodies 11a, ---, and 84a, --- can be recognized. For example, when the marked bodies 84a - 84d in a shape as shown in FIG. 6A are formed on the PD chip 80 side, and the marked bodies 11a - 11d in a shape as shown in FIG. 6B are formed on the PLC 20 side, an image in a shape as shown in FIG. 6C is observed on a recognition screen. Highly accurate mounting can be achieved by aligning the marked bodies 11a, --- and the marked bodies 84a, --- in such a manner that the centers thereof match with each other. In FIG. 6B, the cylindrical parts 12a - 12d are illustrated in the peripheries of the marked bodies 11a-11d, respectively.

FIGS. 7A and 7B show the marked body of the first exemplary embodiment, in which FIG. 7A is a plan view, and FIG. 7B is a longitudinal sectional view taken along a line I-I of FIG. 7A. Explanations will be provided hereinafter by referring to those drawings. Same numeral references are applied to the same components as those of FIG. 1, and explanations thereof are omitted.

FIGS. 7A and 7B are fragmentary views showing a part of the PLC 20 that is shown in FIG. 3. The lower clad layer 62, the marked body 11a, the cylindrical part 12a, the buried layer 64, and the upper clad layer 65 are laminated on the silicon substrate 61. The marked body 11a is formed with a void that is formed in the buried layer 64 made with a silicon oxide film. A void is merely a cavity or a gap, so that heat as high as the limit of the material of the periphery of the void can be applied. Therefore, the heat resistance can be improved dramatically compared to the case of the marked body that is made of metal or the like. Moreover, the refractive index within the void is about 1, so that it is possible to have a sufficient difference between the diffractive index of the material of the periphery of the void and the diffractive index within the void. This makes it possible to achieve a high-contrast marked body. In addition, when the marked body 11a is formed with a pattern within the same mask as the mask for forming the core, the relative position thereof with respect to the core can be maintained with extremely high precision. Furthermore, the manufacturing steps can be simplified compared to the case of the marking made of metal, since it is unnecessary to form a metal film and perform etching.

Since the PLC 20 includes the marked body 11a, it is possible to increase the temperature of heat treatment as high as necessary without minding the heat resistance of the marked body 11a. Therefore, the waveguide with less propagation loss can be achieved.

FIGS. 8A -8E show sectional views showing a manufacturing method of the PLC including the marked body shown in FIGS. 7A and 7B, and steps are executed in order from FIG. 8A to FIG. 8E. Explanations thereof will be provided hereinafter by referring to those drawings.

First, the lower clad layer 62 made of a silicon oxide film is formed on the silicon substrate 61 by plasma CVD. Thereafter, heat treatment is applied with a prescribed condition (FIG. 8A) . Subsequently, a core layer 63a is formed on the lower clad layer 62 by plasma CVD. Thereafter, heat treatment is applied again with a prescribed condition (FIG. 8B). In this heat treatment, unlike the conventional case, it is unnecessary to mind the heat resistance of the marked body. It is the same for the heat treatment performed hereinafter.

Subsequently, a prescribed-shaped resist pattern is formed on the core layer 63a by photolithography, and the core layer 63a is etched to form the core 63 and the cylindrical parts 12a, 12b (FIG. 8C). At this time, the core 63 and the cylindrical parts 12a, 12b are formed simultaneously by the patterns within the same mask of the photolithography. Thus, the core 63 and the marked bodies 11a, 11b formed with the voids can be formed simultaneously by performing photolithography once, so that the voids, i.e. the marked bodies 11a, 11b, can be located extremely accurately with respect to the core 63. The above-described same layer as the core 63, in which the voids as the marked bodies 11a, 11b are formed, corresponds to the core layer 63a.

FIG. 9 shows an example of the mask used therein. FIG. 9 is a fragmentary view of a single PLC extracted from the mask that is used in practice. In FIG. 9, a pattern 63b for forming the core and patterns 12e - 12h for forming the cylindrical parts are provided on a same mask 30. A photoresist film corresponding to the mask 30 is a positive type, so that the part where ultraviolet light transmitted through the mask 30 is irradiated is removed by a developer.

Subsequently, the buried layer 64 is formed thereon, and heat treatment is applied to fuse the buried layer 64. With this, the core 63 is buried therein and the flatness of the surface is increased, while forming the marked bodies 11a, 11b formed with the voids within the cylindrical parts 12a, 12b (FIG. 8D) . The buried layer 64 is a silicon oxide film having a low melting point (for example, a BPSG film). When the cylindrical parts 12a and 12b are covered by the buried layer 64, a gaseous body is captured to the interfaces thereof to form the voids. That is, the cylindrical parts 12a and 12b have the shapes to surround spaces on the lower clad layer, so that the gaseous body is captured into those spaces. The gaseous body is an atmospheric gas at the time of forming the buried layer 64.

Further, in the step shown in FIG. 8C, it is possible to form the voids within the cylindrical parts 12a and 12b securely through properly setting the width (internal diameter) W and the depth D of the cylindrical pats 12a, 12b, the softening temperature of the buried layer 64, the heat treatment temperature (reflow temperature), and the like. The softening temperature of the buried layer 64 is adjusted by the dopant concentration (concentration of B or P in the case of the BPSG film). The voids are more likely to be generated under each of the following conditions, i.e. when the width W becomes narrower, the heat treatment temperature becomes lower, the softening temperature of the buried layer 64 is higher, or the heat treatment temperature for the buried layer 64 is lower. There are restrictions imposed upon the softening temperature and the heat treatment temperature of the buried layer 64 depending on other properties, e.g. it is necessary to set the diffractive index in accordance with the design. Thus, the proper values for the width W and the depth D in practice are determined empirically, since those values change largely depending on such process conditions. The section of the void becomes a shape of somewhere between an oval to circle due to the heat treatment of the buried layer 64.

Subsequently, the upper clad layer 65 is formed thereon, and heat treatment is applied to complete the basic structure of the PLC 20 (FIG. 8E).

The steps thereafter will be described by referring to FIG. 3 - FIG. 5. First, as shown in FIG. 4 and FIG. 5, the groove 69 is formed by dicing the base structure of the PLC 20 shown in FIG. 8E. Then, the sloping face 70 is formed by performing oblique dicing. Thereafter, the mirror flattening layer 66 is formed thereon, and heat treatment is applied to flatten the part that is to be the mirror. The mirror flattening film 66 is a reflow film, i.e. a silicon oxide film that is easily melted, and it is basically the same material as that of the buried layer 64. At last, the electrodes 67a, 67b, 67c and the mirror 68 are patterned to complete the steps. By mounting the PD chip 80, which is being position-adjusted in the manner described above, on the PLC 20, the optical waveguide device 10 can be obtained. Both can be bonded by solder bumps or by thermo-compression bonding by gold bumps. Further, the optical waveguide device 10 includes the PLC 20 and the PD chip 80 mounted thereon, so that the marked body 11a is not oxidized or shifted in position, unlike the case of the marked body made of metal. Thus, it is possible to mount the PD chip 80 to the PLC 20 with high precision. Therefore, the high-performance, high-quality, and high-precision optical waveguide device 10 can be obtained.

Next, the features of the first exemplary embodiments will be described by referring to FIG. 3 - FIG. 5. In the first exemplary embodiment, the core 63 and the cylindrical parts 12a, --- are formed with a single mask that include a pattern of the core 63 and patterns of the cylindrical parts 12a, ---. The cylindrical parts 12a, --- are formed with the same material as that of the core 63 in this step, so that there is no restriction at all imposed upon the heat treatment temperature. Further, the patterns for forming the cylindrical parts 12a, --- have sufficiently small closed areas, so that this parts are not filled in by the heat treatment applied to the buried layer 64 and are remained as cavities. In other words, it is important to secure, within the cylindrical parts 12a, ---, the gap which is so small that it is not filled by the buried layer 64. Normally, this gap is called a void, and the buried layer 64 is divided or the heat treatment temperature is changed to avoid generation of the voids as much as possible in the normal cases. It is the feature of the first exemplary embodiment, however , to have the voids functioning as the marked bodies 11a, ---. The marked bodies 11a, --- formed with the voids do not shield the light. However, those marked bodies 11a,diffract the light, so that the contrast between other parts and the marked bodies can be made clear. As a result, the contour thereof can be recognized by a camera.

It is noted here that the exemplary embodiment of the present invention is not limited to the one described above. The optical element is not limited to the PD but may be a surface emitting laser or the like, for example. In that case, the direction of the light becomes simply inversed. The gaps for generating the voids are secured inside the cylindrical parts in the above. However, it is not limited to that. Other than the cylindrical shape, it may be a geometrical shape of a typical marked body. Further, while the gaps for generating the voids are described to be in a cylindrical shape formed with the cylindrical part, the shape thereof is not limited to that. The gaps may be formed in a geometrical shape such as a parallel shape, a circular shape, or an oval shape.

Other than filled with a gaseous body, inside the void may be made into a vacuum. For making inside the void into a vacuum, reflow of the buried layer may be performed by vacuum annealing, for example. In that case, used is a technique with which voids are not formed before performing the annealing, and the buried layer is deposited such that the shape thereof is formed somewhat in a hood shape. By forming the voids through softening the buried layer using this technique, it is possible to provide the voids whose inside is vacuum.

Each exemplary embodiment above has been described about the case of the marked body used for alignment. However, the marked body according to the exemplary embodiments of the present invention may be used as a marked body for information recording according to the exemplary embodiment of the present invention. The structure, manufacturing method, functions, effect, and the like of the marked body for information recording are same as those of the marked body for alignment that has been described above. For example, the core, the alignment marked body, and the information recording marked body indicating a manufacture' s serial number, for example, can be formed simultaneously by using the same method for manufacturing the alignment marked body that is described above. In this case, like a pit of an optical disk, a single void may be formed to show 1-bit information. For example, the marked body shown in FIGS. 7A and 7B shows 1-bit information. Alternatively, the voids may be formed in various forms such as numerals, characters, and signs to show various kinds of information. With the information recording marked body according to the exemplary embodiment of the present invention, it is possible to obtain an information recording medium with extremely fine heat resistance, which cannot be achieved in wide-use optical disk and the like. It is noted here that the marked body according to the exemplary embodiment of the present invention can be used not only for alignment and information recording but also for various kinds of applications.

While the invention has been particularly shown and described with reference to exemplary embodiments thereof, the invention is not limited to these embodiments. It will be understood by those of ordinary skill in the art that various changes in form and details may be made therein without departing from the spirit and scope of the present invention as defined by the claims.

### INDUSTRIAL APPLICABILITY

The marked body of the present invention can be applied to various devices that utilize a PLC technique, such as a dispersion compensation device, a variable wavelength light source, a 1-byte delay device for DPSK, etc.

In summary, an embodiment of the invention refers to a marked body that can bear the temperature of heat treatment that is required for a PLC. A lower clad layer, a marked body, a cylindrical part, a buried layer, and an upper clad layer are laminated on a silicon substrate. The marked body is formed with a void that is formed in the buried layer made with a silicon oxide film. Therefore, the heat resistance can be improved dramatically compared to a case of the marked body that is made of metal or the like. Moreover, the refractive index within the void is about 1, so that it is possible to have a sufficient difference between the diffractive index of the material of the periphery of the void and the diffractive index within the void. This makes it possible to achieve a high-contrast marked body.

## Claims

1. A marked body, comprising a marking whose presence is recognized by irradiation of light, wherein
the marking is formed inside a transparent layer, and the marking generates a contrast difference between a periphery and itself by diffracting irradiated light.

2. The marked body as claimed in claim 1, wherein the marking is a void formed inside the layer.

3. The marked body as claimed in claim 1 or claim 2 , wherein the layer is a layer where an optical waveguide of a planar lightwave circuit is formed.

4. The marked body as claimed in claim 3, wherein:
the optical waveguide is formed with a lower clad layer, a core, and an upper clad layer; and
the marked body is formed after being aligned collectively together with the core of the optical waveguide in a step for forming the core of the optical waveguide.

5. The marked body as claimed in claim 4, wherein:
the marking is a void formed within the transparent layer; and
the void exists inside a recessed part that is formed in a layer underneath the transparent layer after being aligned collectively together with the core.

6. The marked body as claimed in any of the preceding claims, wherein a position to be specified is recognized based on the contrast difference generated by the marking between the periphery and the marking itself.

7. The marked body as claimed in any of the preceding claims, wherein a plurality of the markings are combined, and a position to be specified is determined from a positional relation between each of the markings.

8. A marked body manufacturing method for manufacturing a marked body whose presence is recognized by irradiation of light, wherein a marking that generating a contrast difference between a periphery and itself by diffracting irradiated light is formed inside a transparent layer.

9. The marked body manufacturing method as claimed in claim 8, comprising forming a void inside the layer as the marking.

10. The marked body manufacturing method as claimed in claim 8 or claim 9, comprising:
forming an optical waveguide by laminating a lower clad layer, a core, and an upper clad layer in order; and
forming the core after aligning the marking collectively together with the core.

11. The marked body manufacturing method as claimed in claim 10, comprising:
forming a recessed part in a layer underneath the transparent layer after being aligned collectively together with the core, prior to forming the transparent layer inside which the marking is to be formed; and
forming a void as the marking at a position located inside the recessed part when forming the transparent layer.
